**Europäisches Patentamt**

**European Patent Office**

**Office européen des brevets**

(19)

(11) Veröffentlichungsnummer : **0 374 392 B1**

(12) # EUROPÄISCHE PATENTSCHRIFT

(45) Veröffentlichungstag der Patentschrift :
01.07.92 Patentblatt 92/27

(51) Int. Cl.$^5$ : **C04B 35/00, H01L 39/24**

(21) Anmeldenummer : **89118545.6**

(22) Anmeldetag : **06.10.89**

(54) **Verfahren zur Herstellung eines keramischen Hochtemperatur-Supraleiters in Draht- oder Bandform.**

(30) Priorität : **19.10.88 CH 3902/88**

(43) Veröffentlichungstag der Anmeldung :
**27.06.90 Patentblatt 90/26**

(45) Bekanntmachung des Hinweises auf die
Patenterteilung :
**01.07.92 Patentblatt 92/27**

(84) Benannte Vertragsstaaten :
**CH DE FR GB IT LI SE**

(56) Entgegenhaltungen :
**JOURNAL OF MATERIALS SCIENCE LETTERS, Band 7, Nr. 3, März 1988, Seiten 283-284, London, GB; T. GOTO et al.: "Wet spinning ofa single layered perovskite Y-Ba-Cu-O superconductor"**
**SOLID STATE COMMUNICATIONS, Band 66, Nr. 7, April 1988, Seiten 735-738, Pergamon Press plc, GB; P. MURUGARAJ et al.:"Preparation of highly oriented polycrystalline YBa2-yCu3Ox superconductors"**

(73) Patentinhaber : **ASEA BROWN BOVERI AG**
**Haselstrasse**
**CH-5401 Baden (CH)**

(72) Erfinder : **Kloucek, Franz, Dr.**
**Brückenstrasse 10**
**CH-5430 Wettingen (CH)**

**EP 0 374 392 B1**

**Beschreibung**

Technisches Gebiet

Technologie der elektrischen Supraleiter. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs seltene Erden/Ba/Cu/O, führte zu einer beträchtlichen Erweiterung der Anwendungsmöglichkeiten für Supraleiter, da diese Stoffe bereits bei Temperaturen oberhalb 50 K supraleitend werden.

Die Erfindung bezieht sich auf die Weiterentwicklung und Verbesserung von Erzeugnissen aus einem keramischen Hochtemperatur-Supraleiter, wobei den Bedürfnissen der industriellen Grossproduktion Rechnung getragen werden soll.

Insbesondere betrifft sie ein Verfahren zur Herstellung eines keramischen Hochtemperatur-Supraleiters in Drahtoder Bandform, auf der Basis einer supraleitenden Keramik der Klasse $(Y,SE)Ba_2Cu_3O_{6,5+y}$ mit SE = seltenes Erdmetall und $O<y<1$.

Stand der Technik

Es hat sich gezeigt, dass keramische Hochtemperatur-Supraleiter der Klasse $SEBa_2Cu_3O_{6,5+y}$ (SE = seltenes Erdmetall, $O<y<1$) in jeder Hinsicht stark anisotrope Eigenschaften haben. Dies hängt mit der Kristallstruktur (Perowskit-Gitter) zusammen und gilt insbesondere für die kritische Stromdichte $j_c$ (Stromtragfähigkeit). Die Korngrenzen in polykristallienen Keramiken begrenzen die kritischen Stromdichten auf kleine Werte, so dass diese Werkstoffe für die meisten technischen Anwendungen bei der Siedetemperatur von flüssigem Stickstoff (T = 77 K) nicht geeignet sind. Für gesinterte Proben aus polykristallinem $YBa_2Cu_3O_{\approx7}$ wurden bisher kritische Stromdichten $j_c$ bis maximal 1000 A/cm² gemessen. Anwendungen z.B. in Magnetspulen erfordern jedoch Stromdichten, die etwa um einen Faktor 100 höher liegen.

Aus dem Obenstehenden geht hervor, dass ein orientiertes Kristallitgefüge gegenüber wirr und statistisch beliebig angeordneten Kristalliten wesentlich höhere kritische Stromdichten erwarten lässt. Die höchsten Stromdichten $j_c$ von mehr als $10^5$ A/cm² wurden in epitaktisch auf $SrTiO_3$-Einkristallen aufgewachsenen dünnen Supraleiterschichten beobachtet. Dieses Verfahren bedingt jedoch teure Einkristalle als Substrate und lässt sich für die Her stellung von Drähten (Mehrfachfilamente / und Bändern grosser Länge) nicht anwenden. Texturen mit bevorzugter Orientierung der Kristallitachsen können ferner durch Heisspressen und Heiss-Strangpressen von Keramikpulvern erzielt werden. Ueber die Stromtragfähigkeit derartiger Erzeugnisse ist indessen nichts bekannt. Auch sind diese Methoden kaum zur Fertigung von Supraleitern in Draht- oder Bandform zu gebrauchen.

Es ist bekannt, dass kalzinierte Pulver z.B. der Verbindung $YBa_2Cu_3O_{\approx7}$ eine nadelförmige oder plattenförmige Teilchenmorphologie haben können, die von Wachstumsanisotropien herrühren. Die kurze Achse dieser Teilchen entspricht dabei kristallographisch der c-Achse des Gitters. Die langen Achsen der Teilchen geben a- bzw. b-Achse des Gitters wieder, wobei diese Richtungen deutlich höhere kritische Ströme aufnehmen können als die c-Achse. Platten- oder nadelförmige, je aus einem Einkristall bestehende Teilchen können durch Zermahlen von porösen Agglomeraten von orientierten Körnern oder durch Mahlen und Sieben oder durch Trennen von den übrigen Phasen im Magnetfeld bei tiefen Temperaturen (Meissner-Effekt) gewonnen werden.

Aus der Literatur ist ein Effekt bekannt, der als sekundäre Rekristallisation (auch "Riesenkornwachstum") bezeichnet wird. Bei der sekundären Rekristallisation tritt Kornwachstum in einem Gefüge nur bei einer sehr kleinen Zahl von Körnern auf, die als Keime wirken. Die übrigen Körner im Gefüge verändern sich kaum, bis sie vollständig durch das Wachstum der Keime aufgebraucht sind. Die Keime können zu Körnern von bis zu 1 mm wachsen. Falls die Keime vor Beginn des Kornwachstums eine Vorzugsorientierung haben, dann entsteht durch sekundäre Rekristallisation ein Gefüge mit einer entsprechenden Textur. Dieses Phänomen ist unter anderem bei keramischen Magnetwerkstoffen wie Ferriten beobachtet worden. Dabei wurde ein Ferritpulver in einem Magnetfeld zu Grünkörpern gepresst. Nach dem Sintern stellte sich durch sekundäre Rekristallisation eine Vorzugsrichtung der Körner ein, die offensichtlich durch die Orientierung einiger weniger Keime vorgegeben war.

Zum Stand der Technik werden die nachfolgenden Literaturstellen zitiert:
– I-Wei Chen, et al., "Texture Development in $YBa_2Cu_3O_x$ by Hot Extrusion and Hot-Pressing", J.Am. Ceram. Soc. 70, December 1987, C-388 - C-390);
– S.Hayashi et al., "Growth of $YBa_2Cu_3O_{9-}$ Single Crystals from the High Temperature Solution", Japanese Journal of Applied Physics, Vol. 26, No. 7, July 1987, pp. L1197-L1198;

– D.L.Kaiser et al., "Growth of $YBa_2Cu_3O_x$ single crystals", Appl. Phys. Letters 51, 1987, 1040-1042;

– P. Murugaraj et al., "Preparation of highly oriented Polycristalline $YBa_{2-y}Cu_3O_x$ Superconductors", Solid State Communications, Vol. 66, No. 7, 1988, pp. 735-738;

– S.Vieira et al., "A simple device for quick separation of high-Tc superconducting materials", J. Phys.E:Sci. Instrum. 20, 1978, 1292-1293;

– A.L. Stuijts, "Sintering of Ceramic Permanent Magnetic Material", Trans. Brit. Ceram. Soc. 55, 1956, 57-74.

Darstellung der Erfindung

Der Erfindung liegt die Aufgabe zugrunde, ein Verfahren zur Herstellung eines keramischen Hochtemperatur-Supraleiters in Draht- oder Bandform der Klasse $(Y,SE)Ba_2Cu_3O_{6,5+y}$ mit SE = seltenes Erdmetall und $O<y<1$ anzugeben, welches die Erreichung einer möglichst hohen kritischen Stromdichte $j_c$ (Stromtragfähigkeit) gewährleistet und die einfache, rationelle und reproduzierbare Fertigung dünner hochbelastbarer Fasern ermöglicht, die bequem zu Mehrfach-Filamenten weiterverarbeitet werden können. Angestrebt werden kritische Stromdichten $j_c$, die mindestens in der Grössenordnung von $10^4$ $A/cm^2$ liegen.

Diese Aufgabe wird dadurch gelöst, dass im eingangs erwähnten Verfahren 80 bis 95 Gew.-% eines ultrafeinkörnigen Pulvers globulitischer Partikel mit höchstens 1 μm Durchmesser aus einer Hochtemperatur-Supraleiterkeramik der Zusammensetzung $YBa_2Cu_3O_{\approx7}$ oder eines Zwischenprodukts der Zusammensetzung $YBa_2Cu_3O_{\approx5}$ mit 0,5 bis 3 Gew.-% eines Pulvers nadel- und plattenförmiger Partikel mit einer Länge von 10 bis 50 μm gemessen über die längste Achse aus einer Hochtemperatur-Supraleiterkeramik und 4 bis 20 Gew.-% eines organischen Binders in einem Lösungsmittel gemischt, dispergiert und zu einer Suspension aufgeschlämmt werden, dergestalt, dass ein hochviskoser Schlicker erzeugt wird, der durch Strangpressen oder Verspinnen zu einem viskosen Strang mit längsgerichteten nadel- und plattenförmigen Partikeln verarbeitet wird, und dass der besagte Strang getrocknet und stufenweise an Luft langsam auf 650 °C und schliesslich auf 850 bis 950 °C erwärmt wird, wobei die organischen Bestandteile zersetzt, $H_2O$ und $CO_2$ ausgetrieben und das Ganze zu einer Faser aus längsgerichteten Kristalliten des Hochtemperatur-Supraleiters gesintert wird.

Der Kern der Erfindung besteht darin, einen supraleitenden keramischen Körper mit grosser Längenausdehnung herzustellen, der aus bevorzugt in Längsrichtung orientierten Körnern besteht. Dabei liegt die a-b-Ebene der Kristallite in der Längsachse der Faser, während ihre c-Achse quer zur Längsrichtung steht.

Weg zur Ausführung der Erfindung

Die Erfindung wird anhand der nachfolgenden, durch Figuren näher erläuterten Ausführungsbeispiele beschrieben.

Dabei zeigt:

Fig. 1 ein Fliessdiagramm (Blockdiagramm) zur Herstellung einer Hochtemperatur-Supraleiterfaser,

Fig. 2 einen schematischen Längsschnitt (Aufriss) durch eine Vorichtung zur Herstellung einer Hochtemperatur-Supraleiterfaser.

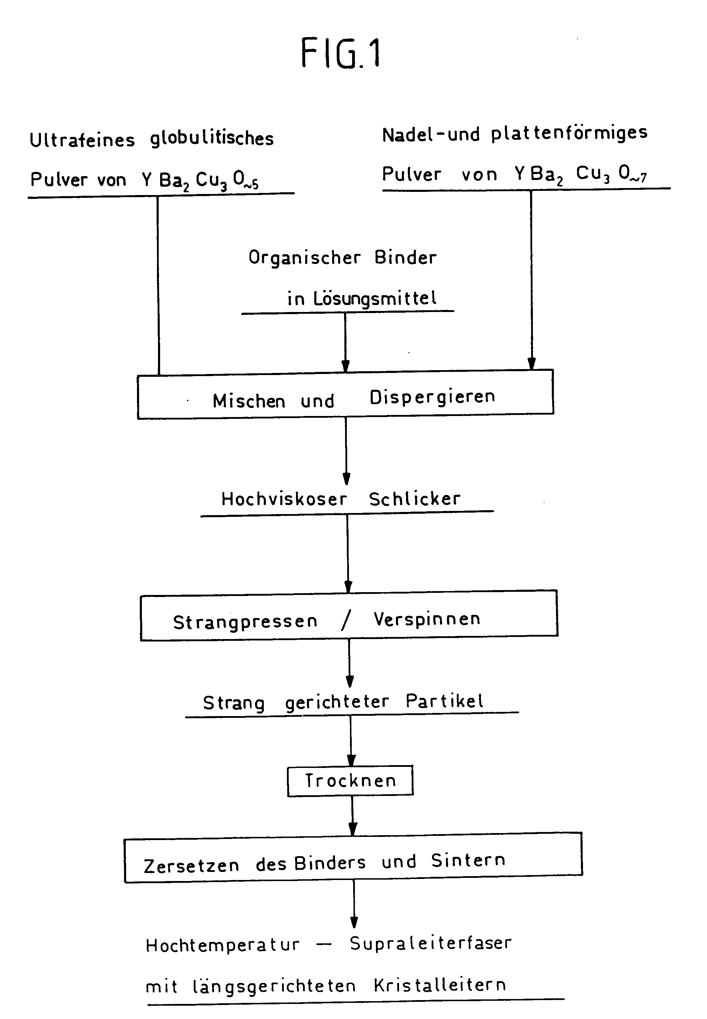

In Fig. 1 ist ein Fliessdiagramm als Blockdiagramm zur Herstellung einer Hochtemperatur-Supraleiterfaser dargestellt. Das Diagramm gilt gleicherweise für die Fertigung von keramischen Hochtemperatur-Supraleitern in Draht- oder Bandform jedweder Art. Das Diagramm bedarf keines speziellen Kommentars. Das ultrafeinkörnige globulitische Pulver wird vorzugsweise durch Copräzipitation aus Lösungen, die Y-, Ba- und Cu-Salze enthalten, hergestellt. Für die Bereitstellung von nadel- und plattenförmigem Pulver stehen die unter dem Stand der Technik erwähnten Verfahren zur Verfügung. Die Weiterverarbeitung des hochviskosen Schlickers erfolgt grundsätzlich durch Strangpressen oder Verspinnen über eine Matrize oder Düse.

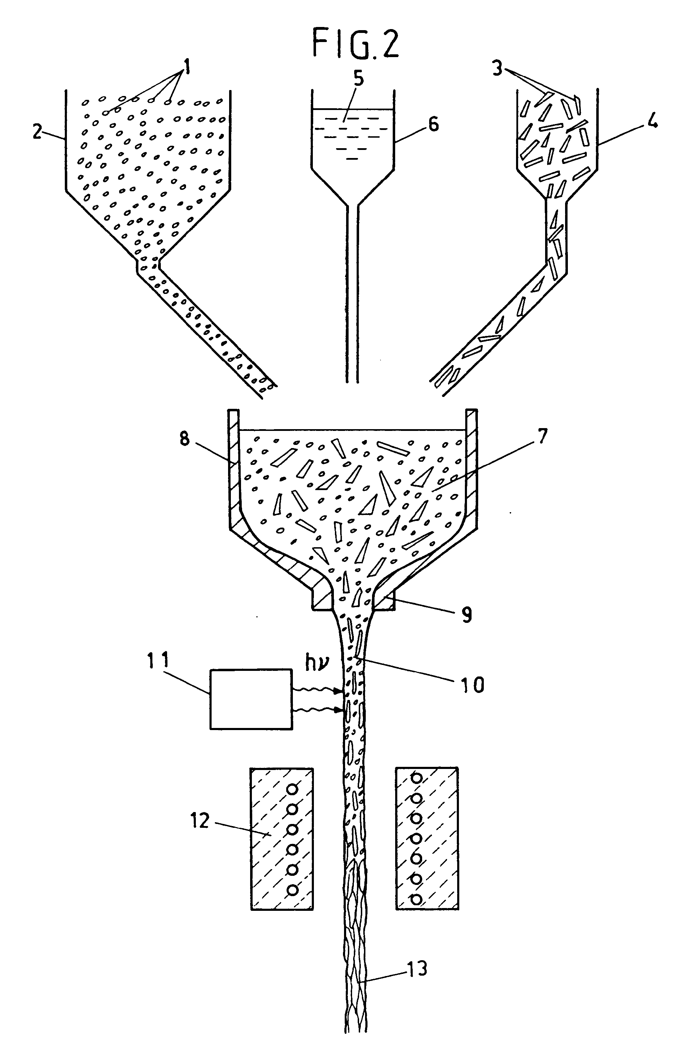

Fig. 2 bezieht sich auf einen schematischen Längsschnitt (Aufriss) durch eine Vorrichtung zur Herstellung einer keramischen Hochtemperatur-Supraleiterfaser. Die Vorrichtung ist vereinfacht nur in ihren Grundelementen dargestellt. 1 ist ein ultrafeinkörniges Pulver globulitischer Partikel aus einer Hochtemperatur-Supraleiterkeramik oder aus einem entsprechenden Zwischenprodukt (Vorläufer). 2 ist ein Behälter für das ultrafeinkörnige Pulver 1. 3 ist ein Pulver nadel- und plattenförmiger Partikel aus einer Hochtemperatur-Supraleiterkeramik, wobei jedes einzelne Partikel aus einem einzigen Kristallit besteht. 4 ist ein Behälter für das Pulver 3 aus nadelförmigen Partikeln. Im Behälter 6 befindet sich ein mit einem Lösungsmittel versetzter organischer Binder (Bezugszeichen 5 für die Mischung). Aus 1+3+5 wird im Gefäss 8 ein hochviskoser Schlicker 7 (Aufschlämmung, Suspension fester Partikel in zähflüssiger "Lösung") gemischt. Das Gefäss 8 besitzt an seinem unteren Ende eine Austrittsöffnung (Düse, Matrize) 9 für den Durchfluss des Schlickers 7. 10 stellt den ausgepressten viskosen Strang dar, der Partikel aus Supraleiterkeramik enthält. Die bevorzugte Textur der nadel- und plattenförmigen Partikel in Längsrichtung des Stranges 10 ist deutlich hervorgehoben. 11 ist eine zum Trocknen des Stranges 10 vorgesehene Infrarot-Strahlungsquelle. Die Strahlung ist durch die Wellenlinien h mit Pfeilrichtung dargestellt. 12 ist ein Ofen zur weiteren Aufheizung des Stranges 10. Er dient zum Austreiben und Zersetzen des organischen Binders und des Lösungsmittels (Austreiben von $H_2O$ und $CO_2$ sowie zum reaktiven Sintern der Partikel aus Supraleiterkeramik. Dabei tritt durch sekundäre Rekristallisation ein beträchtliches Kornwachstum in Längsrichtung ein. Das Ergebnis ist die Faser 13 (Strang) aus längsgerichteten Kristalliten, bestehend aus Supraleiterkeramik.

Ausführungsbeispiel 1:

Siehe Fig. 1 und 2!
Zunächst wurde nach dem Copräzipitationsverfahren aus löslichen Nitraten der Elemente Y, Ba und Cu eine Mischung von unlöslichen Karbonaten und Karbonat-Hydroxyden im Atomverhältnis $Y/Ba_2/Cu_3$ gefällt und dieses Zwischenprodukt durch Glühen (Austreiben des $H_2O$ und $CO_2$) in ein Mischoxyd der ungefähren Zusammensetzung $YBa_2Cu_3O_{\approx5}$ in Form eines ultrafeinkörnigen Pulvers übergeführt. Die mittlere Partikelgrösse dieses im wesentlichen globulitischen Pulvers 1 betrug ca. 0,3 µm. Als Ausgangsmaterial für das Pulver 3 aus nadel- und plattenförmigen Partikeln wurde ein poröses Agglomerat von vergleichsweise gröberen orientierten Körnern der Zusammensetzung $YBa_2Cu_3O_7$ gemäss P. Murugaraj et al verwendet (siehe oben!). Das Agglomerat wurde zermahlen und sortiert. Die mittleren Abmessungen der Kristallite - in der längsten Achse gemessenbetrugen durchschnittlich 30 µm. 85 Gew.-% des ultrafeinkörnigen Pulvers 1 wurden mit 1,5 Gew.-% des Pulvers 3 aus nadel- und plattenförmigen Partikeln in Isopropanol aufgeschlämmt, dispergiert und mit einem Plastifizierungsmittel auf Glykolbasis sowie einem organischen Binder versetzt. Diese inaktiven Substanzen Lösungsmittel + Binder 5 machten den Rest, ca. 13,5 Gew.-% der Mischung aus. Der auf diese Weise hergestellte hochviskose Schlicker 7 wurde in ein Gefäss 8 eingefüllt, von wo er über eine Austrittsöffnung 9 in Form einer feinen Düse zu einer dünnen Faser (Strang 10) ausgepresst wurde. Dadurch wurden die a-b-Ebenen der Kristallite des Pulvers 3 in die Faserlängsachse ausgerichtet. Der Strang 10 wurde im Durchlaufverfahren mittels Infrarot-Strahlen aus der Strahlungsquelle 11 getrocknet und einzelne Faserabschnitte in einem Ofen 12 mit Widerstandsheizung unter sauerstoffhaltiger Atmosphäre langsam auf 600 °C und dann auf 900 °C erhitzt und während 5 h auf dieser Temperatur gehalten. In der ersten Phase wurden demzufolge alle organischen Substanzen zersetzt und das $H_2O$ und $CO_2$ ausgetrieben. In der zweiten Phase wurde dann das reaktive Sintern durchgeführt, wobei durch sekundäre Rekristallisation alle ultrafeinkörnigen Partikel des Pulvers 1 von den gröberen orientierten Kristalliten des Pulvers 3 aufgelöst wurden. Die Faser 13 zeigte eine Textur, die durch die Orientierung der nadel- und plattenförmigen Kristallite des pulvers 3 vorgegeben war.
Eine Untersuchung ergab an der 80 µm dicken Faser 13 bei einer Tempratur von 77 K (Siedepunkt des Stickstoffs) eine kritische Stromdichte $j_c$ von ca. $10^4$ A/cm².

Ausführungsbeispiel 2:

Siehe Fig. 1 und 2!
Aehnlich Beispiel 1 wurde nach dem Copräzipitationsverfahren ein Zwischenprodukt in Pulverform mit dem Atomverhältnis $Y/Ba_2/Cu_3$ hergestellt, welches durch Glühen bei 950 °C in sauerstoffhaltiger Atmosphäre in den supraleitenden keramischen Stoff der ungefähren Zusammensetzung $YBa_2Cu_3O_{\approx7}$ übergeführt wurde. Die mittlere Partikelgrösse dieses ultrafeinkörnigen globulitischen Pulvers 1 betrug ca. 0,5 µm. Das Pulver 3 aus nadel- und plattenförmigen Partikeln mit der ungefähren Zusammensetzung $YBa_2Cu_3O_{\approx7}$ wurde durch Abtrennen von den übrigen Phasen mittels Mahlen und Sieben gemäss D.L. Kaiser et al hergestellt (siehe oben!). Die mittlere Grösse der Kristallite über die längste Achse gemessen betrug ca. 40 µm. Es wurden 90 Gew.-% des ultrafeinkörnigen Pulvers 1 mit 1 Gew.-% des Pulvers 3 aus nadel- und plattenförmigen Partikeln gemäss Beipsiel 1 in Lösungsmitteln unter Zusatz von organischen Bindern 5 und Plastifizierungsmitteln dispergiert, aufgeschlämmt und zu einem hochviskosen Schlicker 7 verarbeitet. Der Schlicker 7 wurde in eine Injektionsspritze abgefüllt und durch eine Hohlnadel mit einer Austrittsöffnung 9 von 120 µm Durchmesser ausgepresst. Der Strang 10 wurde mittels Infrarot-Strahlungsquelle 11 getrocknet und in einem Ofen 12 genau gleich wie unter Beispiel 1 erhitzt. Dabei wurden die organischen Bestandteile zersetzt und das Ganze zu einer Faser 13 mit längsgerichteten Kristalliten zusammengesintert. Die fertige Faser 13 hatte einen Durchmesser von durchschnittlich 75 µm und erreichte bei 77 K eine kritische Stromdichte von ca. $1,2 \times 10^4$ A/cm².

Ausführungsbeispiel 3:

Siehe Fig. 1 und 2!
Es wurde ähnlich Beispiel 1 verfahren. Durch Copräzipitation und Glühen wurde ein ultrafeinkörniges Pulver

der Zusammensetzung $YBa_2Cu_3O_{\approx5}$ mit einer durchschnittlichen Partikelgrösse von 0,4 μm hergestellt. Nach einem leicht abgewandelten Verfahren wurden gröbere Kristallite mit nadelförmiger Struktur der gleichen Zusammensetzung $YBa_2Cu_3O_{\approx5}$; d.h. mit Sauerstoffunterschuss als Pulver 3 hergestellt. Die Mischung der beiden Pulver in einem Verhältnis 95 Gew.-% und 0,7 Gew.-%, Rest organische Zutaten erfolgte in gleicher Weise wie in Beispiel 1 angegeben. Auch die Weiterverarbeitung des Schlickers 7 und des Stranges 10 folgte nach dem gleichen stufenweisen Schema des Beispiels 1. Dabei wurde die gesamte Masse unter Sauerstoffzutritt in den Hochtemperatur-Supraleiter $YBa_2Cu_3O_{\approx7}$ mit längsgerichteter Textur (Faser 13) umgewandelt. Die Stromtragfähigkeit gemessen als kritische Stromdichte $j_c$ für die Faser 13 mit 60 μm Durchmesser betrug ca. $2 \times 10^4$ A/cm$^2$.

Die Erfindung ist nicht auf die Ausführungsbeispiele beschränkt.

Das Verfahren zur Herstellung eines keramischen Hochtemperatur-Supraleiters in Draht- oder Bandform besteht grundsätzlich darin, dass 80 bis 95 Gew.-% eines ultrafeinkörnigen Pulvers 1 globulitischer Partikel mit höchstens 1 μm Durchmesser aus einer Hochtemperatur-Supraleiterkeramik der Zusammensetzung $YBa_2Cu_3O_{\approx7}$ oder eines Zwischenprodukts der Zusammensetzung $YBa_2Cu_3O_{\approx5}$ mit 0,5 bis 3 Gew.-% eines Pulvers 3 nadel- und plattenförmiger Partikel mit einer Länge von 10 bis 50 μm gemessen über die längste Achse aus einer Hochtemperatur-Supraleiterkeramik und 4 bis 20 Gew.-% eines organischen Binders in einem Lösungsmittel 5 gemischt, dispergiert und zu einer Suspension aufgeschlämmt werden, dergestalt, dass ein hochviskoser Schlicker 7 erzeugt wird, der durch Strangpressen oder Verspinnen zu einem viskosen Strang 10 mit längsgerichteten nadel- und plattenförmigen Partikeln verarbeitet wird, und der besagte Strang 10 getrocknet und stufenweise an Luft langsam auf 650 °C und schliesslich auf 850 bis 950 °C erwärmt wird, wobei die organischen Bestandteile zersetzt, $H_2O$ und $CO_2$ ausgetrieben und das Ganze zu einer Faser 13 aus längsgerichteten Kristalliten des Hochtemperatur-Supraleiters gesintert wird.

In einer ersten Variante des Verfahrens hat das ultrafeinkörnige Pulver 1 globulitischer Partikel genau die gleiche Zusammensetzung wie das Pulver 3 nadel- und plattenförmiger Partikel, was der Formel $YBa_2Cu_3O_{\approx5}$ entspricht.

In einer zweiten Variante des Verfahrens hat das ultrafeinkörnige Pulver 1 globulitischer Partikel genau die gleiche Zusammensetzung wie das Pulver 3 nadel- und plattenförmiger Partikel was der Formel $YBa_2Cu_3O_{\approx7}$ entspricht.

Es muss noch betont werden, dass das neue Verfahren keineswegs auf die keramischen Hochtemperatur-Supraleiter der Klasse $(Y,SE)Ba_2Cu_3O_{6,5+y}$ beschränkt ist, sondern auf Supraleiter irgendwelcher Zusammensetzung anwendbar ist, die nadel- oder plattenförmige Kristallstruktur haben und in der Basisebene bevorzugte Supraleitereigenschaften haben. Dies trifft insbesondere auch für die Klassen $Tl_2Ba_2Cu_3O_{8+x}$ und ähnliche sowie die Klassen $Bi_2Sr_{3-x}\,Ca_xCu_2O_{8+y}$ und Verwandte zu.

## Patentansprüche

1. Verfahren zur Herstellung eines keramischen Hochtemperatur-Supraleiters in Draht- oder Bandform, auf der Basis einer supraleitenden Keramik der Klasse $(Y,SE)Ba_2Cu_3O_{6,5+y}$ mit SE = seltenes Erdmetall und $0<y<1$, dadurch gekennzeichnet, dass 80 bis 95 Gew.-% eines ultrafeinkörnigen Pulvers (1) globulitischer Partikel mit höchstens 1 μm Durchmesser aus einer Hochtemperatur-Supraleiterkeramik der Zusammensetzung $YBa_2Cu_3O_{\approx7}$ oder eines Zwischenprodukts der Zusammensetzung $YBa_2Cu_3O_{\approx5}$ mit 0,5 bis 3 Gew.-% eines Pulvers (3) nadel- und plattenförmiger Partikel mit einer Länge von 10 bis 50 μm gemessen über die längste Achse aus einer Hochtemperatur-Supraleiterkeramik und 4 bis 20 Gew.-% eines organischen Binders in einem Lösungsmittel (5) gemischt, dispergiert und zu einer Suspension aufgeschlämmt werden, dergestalt, dass ein hochviskoser Schlicker (7) erzeugt wird, der durch Strangpressen oder Verspinnen zu einem viskosen Strang (10) mit längsgerichteten nadel- und plattenförmigen Partikeln verarbeitet wird, und dass der besagte Strang (10) getrocknet und stufenweise an Luft langsam auf 650 °C und schliesslich auf 850 bis 950 °C erwärmt wird, wobei die organischen Bestandteile zersetzt, $H_2O$ und $CO_2$ ausgetrieben und das Ganze zu einer Faser (13) aus längsgerichteten Kristalliten des Hochtemperatur-Supraleiters gesintert wird.

2. Verfahren nach Anspruch 1, dadurch gekennzeichnet, dass das ultrafeinkörnige Pulver (1) globulitischer Partikel und das Pulver (3) nadel- und plattenförmiger Partikel genau die gleiche Zusammensetzung aufweisen, die der Formel $YBa_2Cu_3O_{\approx5}$ entspricht.

3. Verfahren nach Anspruch 1, dadurch gekennzeichnet, dass das ultrafeinkörnige Pulver (1) globulitischer Partikel und das Pulver (3) nadel- und plattenförmiger Partikel genau die gleiche Zusammensetzung aufweisen, die der Formel $YBa_2Cu_3O_{\approx7}$ entspricht.

## Claims

1. Method for producing a wire- or band-shaped ceramic high-temperature superconductor based on a superconducting ceramic of the $(Y,SE)Ba_2Cu_3O_{6.5+y}$ class with SE = rare earth metal and $0<y<1$, characterised in that 80 to 95% by weight of an ultra-fine grained powder (1) of globulitic particles having a maximum diameter of 1 μm of a high-temperature superconductor ceramic of the $YBa_2Cu_3O_{\approx7}$ composition or of an intermediate product of the $YBa_2Cu_2O_{\approx5}$ composition are mixed with 0.5 to 3% by weight of a powder (3) of needle- and plate-shaped particles having a length of 10 to 50 μm measured over the longest axis of a high-temperature superconductor ceramic and 4 to 20% by weight of an organic binder in a solvent (5), are mixed, dispersed and suspended to form a suspension in such a manner that a highly viscous slip (7) is created which is processed by extrusion or spinning to form a viscous strand (10) having longitudinally oriented needle- and plate-shaped particles and in that the said strand (10) is dried and slowly heated in air step by step to 650°C and finally to 850 to 950°C, during which process the organic components are decomposed, $H_2O$ and $CO_2$ are expelled and the whole is sintered to form a fibre (13) of longitudinally oriented crystallites of the high-temperature superconductor.

2. Method according to Claim 1, characterised in that the ultra-fine grained powder (1) of globulitic particles and the powder (3) of needle- and plate-shaped particles have precisely the same composition as corresponds to the formula $YBa_2Cu_3O_{\approx5}$.

3. Method according to Claim 1, characterised in that the ultra-fine grained powder (1) of globulitic particles and the powder (3) of needle- and plate-shaped particles has precisely the same composition as corresponds to the formula $YBa_2Cu_3O_{\approx7}$.

## Revendications

1. Procédé pour la fabrication d'un supraconducteur à haute température en céramique sous forme de fil ou de ruban métallique, sur la base d'une céramique supraconductrice de la classe $(Y,SE)Ba_2Cu_3O_{6.5+y}$ dans laquelle SE = metal de terres rares et $0<y<1$, caracterisé en ce que 80 à 95 % en poids d'une poudre à grains ultrafins (1) de particules microlithiques ayant au maximum 1 μm de diamètre et provenant d'une céramique supra-conductrice à haute température de composition $YBa_2$-$Cu_3O_{\approx7}$ ou bien d'un produit intermédiaire de composition $YBa_2Cu_3O_{\approx5}$ avec 0,5 à 3 % en poids d'une poudre (3) de particules en forme d'aiguilles et de lamelles ayant une longueur de 10 à 50 μm mesurée sur l'axe le plus long et provenant d'une céramique supra-conductrice à haute température sont mélanges dans un solvant (5) avec 4 à 20 % en poids d'un liant organique, le tout étant disperse et mis en suspension, de telle manière que soit produite une barbotine fortement visqueuse (7) qui est transformée par étirage sous pression ou filage en un écheveau visqueux (10) aux particules longitudinales en forme d'aiguilles et de lamelles et que ledit écheveau (10) soit seche, puis graduellement et lentement chauffe à l'air jusqu'à 650°C, pour être finalement amené à une température de 850 à 950°C, point auquel les composants organiques sont décomposes, $H_2O$ et $CO_2$ sont élimines et que le tout soit fritte en une fibre (13) faite de cristallites longitudinales de supraconducteur à haute température.

2. Procédé selon la revendication 1, caractérisé en ce que la poudre à grains ultrafins (1) de particules microlithiques et la poudre (3) de particules en forme d'aiguilles et de lamelles ont exactement la même composition, qui correspond à la formule $YBa_2Cu_3O_{\approx5}$.

3. Procédé selon la revendication 1, caractérisé en ce que la poudre à grains ultrafins (1) de particules microlithiques et la poudre (3) de particules en forme d'aiguilles et de lamelles ont exactement la même composition, qui correspond à la formule $YBa_2Cu_3O_{\approx7}$.

# FIG.1

Ultrafeines globulitisches
Pulver von $Y Ba_2 Cu_3 O_{\sim 5}$

Nadel-und plattenförmiges
Pulver von $Y Ba_2 Cu_3 O_{\sim 7}$

Organischer Binder
in Lösungsmittel

Mischen und Dispergieren

Hochviskoser Schlicker

Strangpressen / Verspinnen

Strang gerichteter Partikel

Trocknen

Zersetzen des Binders und Sintern

Hochtemperatur — Supraleiterfaser
mit längsgerichteten Kristalleitern

7

# FIG.2